# EUROPEAN PATENT SPECIFICATION

(11) **EP 0 560 733 B1**
(45) Date of publication and mention of the grant of the patent: **19.03.1997**
(21) Application number: 93830029.0
(22) Date of filing: 29.01.1993
(51) Int. Cl.: H05K 7/12

(54) **Electronic circuit mount with anchorage fins on sides**
Träger für elektronische Schaltungselemente mit Verankerungsstegen an den Seiten
Support pour des composants électroniques ayant des ailettes de fixation aux flancs

(30) Priority: 13.02.1992 IT AR920003
(43) Date of publication of application: 15.09.1993
(73) Proprietor: MAGNETEK S.p.A., I-52028 Terranuova Bracciolini (AR) (IT)
(72) Inventor: Canova, Antonio, I-52025 Montevarchi (IT)
(74) Representative: Berneschi, Ciro

(56) References cited:
- EP-A- 0 226 042
- US-A- 2 616 643

## Description

The invention concern an electronic circuit mount with anchorage fins on at least one side surface, for anchoring ventilators and other bulky components.

Sheet metal mounts used in electromechanical engineering, and electronics in particular, contain electric and/or electronic circuits of the kind that are printed onto a board, or relatively bulky components, such as cooling fans, speakers and other, which are anchored directly into the mount with nuts and bolts. These mounts contain the electric and electronic circuitry and other components that make up the internal working parts of computers, television sets, radios and other apparatus.

The anchorage of bulky components using nuts and bolts is a particulary costly operation, requiring, each time, the manual intervention of workers, because, due to lack of space inside the mount, servomechanisms used for assembly cannot reach the points where the anchorage bolts are to be fixed.

The state of the art does not offer rapid, versatile, economical means for the anchorage of bulky, commercial elements to the mount with the aid of folding fins.

One anchorage system using fins is indicated in patent EP-A-0226042.

This illustrates the anchorage of a base to an indented recess in a plate with the aim of giving maximum contact and enhancing the diffusion of heat from the base to the plate.

This entails the addition of anchorage flaps to the plate using wings of fins which are bent over the base.

A second anchorage system with fins is illustrated in patent US-A-2616643.

This involves the presence of a shaped plate fixed to the component that needs to be anchored, equipped with protruding fins used to fit into holes made in the plate where the component is to be anchored.

This invention regards the introduction of a new structure to standard mounts which simplifies the anchorage of relatively bulky components that are currently fixed inside the mount with nuts and bolts.

This means their anchorage can be automatized thus cutting operating costs regardless of the amount and thickness of the circuits held in the mount, and without the use of additional plates or the occupation of space inside the mount, which would lead to alterations in the positioning of the other components housed therein.

The new structure of the mounts that offer a different kind of anchorage and the automation of this operation, consists of a new, functional shape obtained from a metal sheet from which the base and at least one side surface originate, in correspondence with the positions in which the bulky components to be anchored, are to be located.To be more specific, the new structure consists of fins on the sides of the mount positioned at different heights from its base, that can be bent inwards, shaped in such a way that they can be adjusted to increase their pressure on the structure to be anchored so they do not work loose over time.

A mount with sides thus shaped, has the added function of becoming an anchorage system for bulky components placed inside it, as well as being a support for them.

With this mount the use of secondary anchorage elements such as back-up plates bolts, nuts and spring washers is eliminated, and assemblage difficulties present when having to mount densely packed circuits by inserting bolts and screwing on nuts, are overcome.

The invention consists of an electronic circuit mount having a base and at least one sheet metal side surface having pairs of fins which point in opposite directions for anchoring ventilators and other bulky components therein, each fin having a slanting bottom edge that tapers towards its free end and is designed to work by rotating it in a plane parallel to the base of the mount, so that it undergoes pressure by tearing from the anchored component, said fins are formed from said at least one side surface and they are bent towards the space between said base and at least one side surface of the mount, to anchor the bulky component to the base, with the base and the at least one side surface formed by the bending of only one metal sheet.

Using a mount with sides shaped in this way, relatively bulky components are anchored by bending the fins using a lateral rotation so they make contact with the top of the components to be anchored, or interact with teeth or indentations in the body of these components.

Quick anchorage fins made in this way are particularly efficient in their working, because they undergo pressure by tearing from the anchored component and for this reason they remain particularly resistant and rigid over time and do not allow the anchored component to work loose.

The invention is described in detail below with reference to illustrative drawings on the table attached, in which:
- figure 1 is the front view of a section of one of the thin metal sides of a mount, equipped, at the top, with two fins designed to be bent by rotation on a plane parallel to the base of the mount from which the side emerges;
- figure 2 is the view in perspective of a part of a mount made of flexible non elastic sheet metal, with two facing sides each of which is equipped, at the top, with two anchorage fins, showing one pair in their working position;
- figure 3 is a top view of part of a mount with fan equipped with holes for bolts, held in its working position by two pairs of fins located on the lateral, opposite sides of the mount;
- figure 4 is the side view of part of a mount with two quick anchorage fins located at the top of one of the sides, and two protrusions near the base intended to keep a bulky component to be anchored raised from the base;
- figure 5 illustrates the anchorage of a component using two fins located around the middle of the side of the mount in conjunction with two recesses in the component.

It must be made clear, however, that the drawings serve only to exemplify the invention, with the sole aim of facilitating its comprehension.

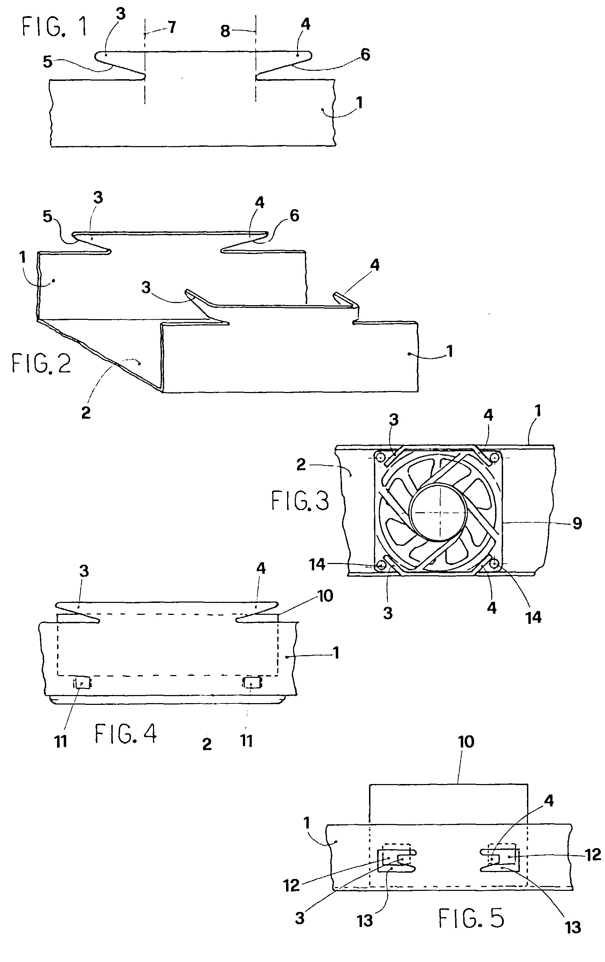

In the drawings, the number 1 represents the thin sheet metal sides of the mount, 2 is its base, 3 and 4 a pair of anchorage fins facing in opposite directions, 5 and 6 are the slanting edges along the bottom of the fins, 7 and 8 are the axes around which the fins 3 and 4 are turned when brought into their working position, 9 shows a fan held in place by two pairs of fins 3 and 4 located on the two opposite sides of the mount, 10 represents any kind of bulky component which in figure 4 is anchored at the top with fins 3 and 4, whilst in figure 5, it is anchored via the two recesses 12 made in its surface.

The number 11 shows two protrusions on the side 1, which emerge from the side surfaces towards the inside of the mount and are designed to act as a support for the component 10 to be anchored, which is raised from the base 2 of the mount.

The fins 3 and 4 can be located on the top of the side surfaces 1 of the mount, as shown in figures 1, 2, 3 and 4, or they can be located in the side surfaces 1 at different heights from the base 2, including the central position, as shown in figure 5, and in such a case said fins are surrounded along three sides of their outline from an empty space 13.

The mount in question is therefore equipped with a base 2 and at least one thin metal side 1, and usually with a pair of fins 3 and 4, preferably facing opposite ways, and generally made of thin sheet metal or alloy that is flexible, but not elastic. The height of the side or sides 1, is variable, depending on whether there are bulky objects to be anchored, or other circuits and components to be housed inside the mount. The anchorage fins, which normally number two, are usually placed to face in opposite directions because, in this way, when bent, they serve to centralize the component to be anchored, which could be equipped with rabbets to receive the fins. There could be one, two, or more fins on each side.

These fins 3 and 4 are designed to work with bulky components that need anchoring in such a way that the fins remain perpendicular to these objects even though the angle of their rotation could vary. Likewise, the rotation axes or lines 7 and 8, around which the fins rotate, are perpendicular to the base 2 of the mount or to the surface determined by the support of the protrusions 11. The fins 3 and 4, are normally an equal distance from the base 2, but could be at differing heights and therefore independent from each other, in relation to the shape of the component 10 to be anchored.

These fins have, along the bottom, slanting edges 5 and 6, at an angle to the surface of the component to be anchored. This allows them to work with components with slightly differing heights, interacting with different points of the fin that are closer to, or further from its tip, and to apply differing pressure on the same component 10 to be anchored, normally made of non-rigid material, varying the amount of rotation of the fins around the lines 7 and 8 or around lines parallel to these.

The sides 1 of the mount in question can vary in size, in number and in their outline, whilst the anchorage fins can also vary in shape and providing they are bent around an axis perpendicular to the base where the component to be anchored rests, and they still have slanting bottom edges 5 and 6 that work on differing heights and/or with differing pressures.

## Claims

1. Electronic circuit mount having a base (2) and at least one thin sheet metal side surface (1) having pairs of fins (3, 4) for anchoring ventilators and other bulky components therein, each fin having a slanting bottom edge (5, 6) that tapers towards its free end and is designed to work by rotating it on a plane parallel to the base of the mount, so that it undergoes pressure by tearing from the anchored component, said fins (3, 4) are formed from said at least one side surface (1) and they are bent inwards, towards the space between said base (2) and said at least one side surface of the mount to anchor the bulky component to the base, characterised in that one bent metal sheet forms said base and said at least one side surface of the mount.

2. Electronic circuit mount, as claimed in claim 1., in which the fins (3, 4) are characterised in that they are located in positions at different heights from the base (2), including the central position on the at least one side surface (1).

3. Electronic circuit mount, as claimed in claim 1, consisting of a base with side surfaces (1) equipped with fins (3, 4), characterised in that the height of the side surfaces (1) is variable.

4. Electronic circuit mount, as claimed in claim 1., including side surfaces (1) characterised by protrusions (11) which emerge from the side surfaces towards the space between said side surfaces of the mount, said protrusions are designed to act as a support for the component (10) to be anchored, which is thus raised from the base (2) of the mount.

5. Electronic circuit mount, as claimed in claims 1.and 4., consisting of a base with side surfaces equipped with anchorage fins (3, 4) which correspond to points where bulky components are to be housed, characterised in that the fins are designed to be bent, to reach their working position, rotating on axes perpendicular to the base of the mount on which the component (10) is to be anchored, or to the plane defined by the protrusions (11).

## Patentansprüche

1. Träger für elektronische Schaltungselemente mit einem Unterteil (2) und wenigstens einer dünnblechigen Seitenfläche (1), die Stegpaare (3, 4) zum Verankern von Ventilatoren und anderen größeren Komponenten darin aufweist, wobei jeder Steg eine schräge Unterkante (5, 6) hat, die sich zu ihrem freien Ende hin verjüngt und so arbeitet, daß man sie in einer zum Unterteil des Trägers parallelen Ebene dreht, so daß durch Ziehen ein Druck von der verankerten Komponente auf sie einwirkt, wobei die Stege (3, 4) aus der wenigstens einen Seitenfläche (1) gebildet und nach innen, in den Raum zwischen dem Unterteil (2) und der wenigstens einen Seitenfläche des Trägerteils, gebogen sind, um die größere Komponente an dem Unterteil zu verankern,
dadurch gekennzeichnet,
daß ein umgebogenes Metallblech das Unterteil und die wenigstens eine Seitenfläche des Trägers bildet.

2. Träger für elektronische Schaltungselemente gemäß Anspruch 1, wobei die Stege (3, 4) dadurch gekennzeichnet sind, daß sie in Positionen unterschiedlicher Höhe über dem Unterteil (2) angeordnet sind, einschließlich einer mittleren Position auf der wenigstens einen Seitenfläche (1).

3. Träger für elektronische Schaltungselemente gemäß Anspruch 1, der aus einem Unterteil mit Seitenflächen (1) besteht, die Stege (3, 4) aufweisen, dadurch gekennzeichnet, daß die Höhe der Seitenflächen (1) variabel ist.

4. Träger für elektronische Schaltungselemente gemäß Anspruch 1, der Seitenflächen (1) umfaßt, gekennzeichnet durch Vorsprünge (11), die von den Seitenflächen in den Raum zwischen den Seitenflächen des Trägers hineinragen, wobei die Vorsprünge als Halter für die zu verankernde Komponente (10) dienen, die so von dem Unterteil (2) des Trägers abgehoben ist.

5. Träger für elektronische Schaltungselemente gemäß Anspruch 1 und 4, der aus einem Unterteil mit Seitenflächen besteht, die mit Verankerungsstegen (3, 4) versehen sind, welche den Stellen entsprechen, wo größere Komponenten untergebracht werden sollen, dadurch gekennzeichnet, daß die Stege durch Umbiegen in ihre Arbeitsposition gebracht werden können, wobei sie sich um Achsen drehen, die senkrecht zu dem Unterteil des Trägers auf welchem die Komponente (10) verankert werden soll, oder senkrecht zu einer Ebene, die durch die Vorsprünge (11) definiert ist, verlaufen.

## Revendications

1. Support de circuits électroniques ayant une base (2) et au moins une surface latérale métallique en feuille mince (1) comportant des couples d'ailettes (3, 4) pour ancrer des ventilateurs et autres composants encombrants en leur sein, chaque ailette ayant un bord de dessous incliné (5, 6) qui va en s'amincissant vers son extrémité libre, est conçue pour fonctionner en la faisant pivoter sur un plan parallèle à la base du support, de sorte qu'elle subit une pression par arrachement provenant du composant ancré, lesdites ailettes (3, 4) sont formées à partir de ladite au moins une surface latérale (1) et elles sont pliées vers l'intérieur, vers l'espace entre ladite base (2) et ladite au moins une surface latérale du support pour ancrer le composant encombrant à la base, caractérisé en ce qu'une seule feuille de métal pliée forme ladite base et ladite au moins une surface latérale du support.

2. Support de circuits électroniques selon la revendication 1, dans lequel les ailettes (3, 4) sont caractérisées en ce qu'elles sont situées dans des positions à différentes hauteurs à partir de la base (2), incluant la position centrale sur l'au moins une surface latérale (1).

3. Support de circuits électroniques selon la revendication 1, constitué d'une base ayant des surfaces latérales (1) munies d'ailettes (3, 4), caractérisé en ce que la hauteur des surfaces latérales (1) est variable.

4. Support de circuits électroniques selon la revendication 1, comprenant des surfaces latérales (1) caractérisées par des protubérances (11) qui font saillie à partir des surfaces latérales vers l'espace entre lesdites surfaces latérales du support, lesdites protubérances sont conçues pour servir d'appui pour le composant (10) à ancrer, lequel est ainsi élevé par rapport à la base (2) du support.

5. Support de circuits électroniques selon les revendications 1 et 4, comprenant une base ayant des surfaces latérales munies d'ailettes d'ancrage (3, 4) qui correspondent aux points où des composants encombrants sont à loger, caractérisé en ce que les ailettes sont conçues pour être pliées, pour atteindre leur position fonctionnelle, tournant sur des axes perpendiculaires à la base du support sur lequel le composant (10) est à ancrer, ou au plan défini par les protubérances (11).
